(19) Europäisches Patentamt
European Patent Office
Office européen des brevets

(11) **EP 3 770 968 B1**

(12) **FASCICULE DE BREVET EUROPEEN**

(45) Date de publication et mention
de la délivrance du brevet:
**09.02.2022 Bulletin 2022/06**

(21) Numéro de dépôt: **20185102.9**

(22) Date de dépôt: **09.07.2020**

(51) Classification Internationale des Brevets (IPC):
**H01L 27/146** *(2006.01)* **H01L 27/15** *(2006.01)*

(52) Classification Coopérative des Brevets (CPC):
**H01L 27/14627; H01L 27/14687;** H01L 27/156

(54) **PROCEDE DE MISE EN COURBURE COLLECTIVE D'UN ENSEMBLE DE PUCES ELECTRONIQUES**

VERFAHREN ZUR KOLLEKTIVEN BIEGUNG EINER GESAMTHEIT VON ELEKTRONISCHEN CHIPS

METHOD FOR COLLECTIVE CURVATURE OF A SET OF ELECTRONIC CHIPS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.07.2019 FR 1908529**

(43) Date de publication de la demande:
**27.01.2021 Bulletin 2021/04**

(73) Titulaire: **Commissariat à l'Energie Atomique et aux Energies Alternatives**
**75015 Paris (FR)**

(72) Inventeurs:
• **CHAMBION, Bertrand**
**38054 GRENOBLE Cedex 09 (FR)**
• **COLONNA, Jean-Philippe**
**38054 GRENOBLE Cedex 09 (FR)**

(74) Mandataire: **INNOV-GROUP**
**310, avenue Berthelot**
**69372 Lyon Cedex 08 (FR)**

(56) Documents cités:
**US-A1- 2009 115 875 US-B2- 7 397 066**

EP 3 770 968 B1

## Description

### Domaine technique

L'invention se rapporte au domaine technique de la mise en courbure collective de puces électroniques. Par « collective », on entend une mise en courbure à l'échelle de la tranche (WLP pour « *Wafer Level Process* » en langue anglaise) sur laquelle sont formées les puces électroniques.

L'invention trouve notamment son application dans la fabrication de capteurs d'images incurvés, ou d'afficheurs incurvés, pouvant être intégrés à un système optique (e.g. un objectif photographique) afin d'augmenter la compacité du système optique, ou d'en améliorer les performances optiques (e.g. compenser la courbure de champ, l'astigmatisme).

### État de l'art

Un procédé de mise en courbure collective de puces électroniques connu de l'état de la technique, notamment du document US 2006/0038183 A1 (ci-après D1), comporte une étape consistant à agencer des unités de fléchissement («*flexor unit»*) pour incurver les puces électroniques.

En particulier, D1 divulgue (fig. 5, §0035-36) des unités de fléchissement agencées sous le substrat (face arrière) comportant les puces électroniques à incurver, chaque unité comportant :

- un élément central, formé sous le substrat ;
- des espaceurs («*spacers*»), s'étendant de part et d'autre de l'élément central, et formé sous le substrat ;
- une plaque («*plate*»), reliant l'élément central aux espaceurs.

Les espaceurs et l'élément central possèdent des coefficients de dilatation thermique différents de sorte qu'en appliquant un traitement thermique, il est possible d'incurver le substrat, et par là-même les puces électroniques.

Par ailleurs, D1 divulgue (fig. 8, 0039) des unités de fléchissement agencées sous le substrat (face arrière) comportant les puces électroniques à incurver, chaque unité comportant :

- un premier matériau, formé sous le substrat ;
- un second matériau, formé sous le premier matériau.

Les premier et second matériaux possèdent des coefficients de dilatation thermique différents de sorte qu'en appliquant un traitement thermique, il est possible d'incurver le substrat, et par là-même les puces électroniques.

Un tel procédé de l'état de la technique n'est pas entièrement satisfaisant dans la mesure où les unités de fléchissement complexifient la mise en œuvre du procédé car il est nécessaire de prévoir plusieurs éléments structurels additionnels (espaceurs, plaques). En outre, les unités de fléchissement augmentent le temps d'opération puisque la mise en courbure et l'individualisation des puces électroniques sont des étapes exécutées séparément, la mise en courbure étant effectuée avant l'individualisation des puces électroniques. Enfin, la présence d'unités de fléchissements ne permet pas de réaliser aisément des contacts électriques en face arrière du substrat afin d'assurer une liaison électrique avec un boîtier ou une carte électronique.

Le document US 2009/115875 A1 décrit un procédé de courbure d'un ensemble de puces électroniques.

### Exposé de l'invention

L'invention vise à remédier en tout ou partie aux inconvénients précités. A cet effet, l'invention a pour objet un procédé de mise en courbure collective d'un ensemble de puces électroniques, comportant les étapes :

    a) prévoir l'ensemble de puces électroniques, comportant un empilement comprenant :

-     un ensemble de matrices de pixels,
-     une couche d'interconnexions, reliée électriquement à l'ensemble de matrices de pixels,
-     une première couche, comprenant des trous d'interconnexions reliés électriquement à la couche d'interconnexions ;
l'empilement possédant une première épaisseur et un premier coefficient de dilatation thermique ;

    b) former des piliers métalliques sur la première couche, reliés électriquement aux trous d'interconnexions ;
    c) former un matériau de manière solidaire avec la première couche, autour des piliers métalliques ; le matériau possédant une seconde épaisseur, un second coefficient de dilatation thermique strictement supérieur au premier coefficient de dilatation thermique, et une température de formation ;
    d) découper les puces électroniques de manière à libérer les contraintes thermomécaniques subies par l'empilement ; la température de formation, le ratio entre les premier et second coefficients de dilatation thermique et le ratio entre les première et seconde épaisseurs étant adaptés de sorte qu'à l'issue de l'étape d), l'empilement est incurvé selon une forme convexe prédéterminée, orientée vers l'ensemble de matrices de pixels, à une température de fonctionnement donnée des puces électroniques ;
    e) rendre coplanaires les piliers métalliques après l'étape d).

Ainsi, un tel procédé selon l'invention permet d'effectuer la mise en courbure lors de l'individualisation des puces électroniques, c'est-à-dire lors de la découpe de l'étape d), qui libère les contraintes thermomécaniques subies par l'empilement. Ceci est rendu possible grâce au matériau formé de manière solidaire avec l'empilement. En outre, un tel procédé selon l'invention ne nécessite que la formation du matériau sur l'empilement, et donc pas d'éléments de structure additionnels tels que des plaques reliant des espaceurs. Enfin, la coplanarité des piliers métalliques obtenue à l'étape e) permet de réaliser aisément des contacts électriques coplanaires à partir des piliers métalliques, afin d'assurer une liaison électrique avec un boîtier ou une carte électronique (par exemple à l'aide de billes de soudure). Les trous d'interconnexions de la première couche permettent d'obtenir une connexion électrique, et améliorent par ailleurs la cohésion mécanique de l'empilement en réduisant les risques de délamination.

**Définitions**

- Par «puce électronique » («*die* » ou «*chip*» en langue anglaise), on entend une partie d'un substrat ayant subie des étapes technologiques en vue de former un composant électronique destiné à être monté sur une carte électronique ou dans un boîtier.
- Par « substrat », on entend un support physique autoporté, pouvant être par exemple une tranche («*wafer*» en langue anglaise) découpée dans un lingot monocristallin de matériau semi-conducteur.
- Par « pixels », on entend :

  les cellules photosensibles (appelées également photosites) dans le cas d'une puce électronique d'un capteur d'images,
  les cellules émettrices de lumière (ou émissives) dans le cas d'une puce électronique d'un afficheur.

- Par « couche d'interconnexions », on entend un empilement de niveaux d'interconnexions comprenant des pistes métalliques noyées dans un matériau diélectrique.
  Par « trou d'interconnexion » («*via* » en langue anglaise), on entend un trou métallisé permettant d'établir une liaison électrique avec la couche d'interconnexions. Dans le cas où la première couche est réalisée en silicium, le trou d'interconnexion est de type TSV («*Through Silicon Via* » en langue anglaise).
- Par « formé de manière solidaire », on entend que le matériau est solidaire mécaniquement de la première couche de l'empilement, c'est-à-dire que le matériau présente une énergie d'adhérence suffisante pour obtenir la mise en courbure et éviter son décollement de l'empilement.
- Par « libérer les contraintes thermomécaniques », on entend le fait de convertir les contraintes thermomécaniques subies par l'empilement en déformation (courbure).

- Par « prédéterminée », on entend la forme convexe souhaitée pour l'application envisagée.
- Par « orientée vers l'ensemble de matrices de pixels », on entend que la forme convexe obtenue à l'issue de l'étape d) définit des surfaces convexes (bombées) au sein de l'empilement qui pointent vers la surface libre de l'empilement, du côté de l'ensemble de matrices de pixels, à l'opposé des piliers métalliques.
- Par «coplanaires », on entend que les extrémités libres des piliers métalliques s'étendent dans un même plan avec une tolérance de 100 $\mu$m, préférentiellement de 50 $\mu$m, plus préférentiellement de 25 $\mu$m. La tolérance correspond à la distance maximale entre le plan et une extrémité libre d'un pilier métallique. On choisira avantageusement une tolérance inférieure au quart de la dimension caractéristique (e.g. diamètre) des billes de soudure envisagées pour assurer une liaison électrique entre les piliers métalliques et un boîtier (ou une carte électronique). Par exemple, pour des billes de soudure possédant un diamètre de 100 $\mu$m, la tolérance est inférieure à 25 $\mu$m.

Le procédé selon l'invention peut comporter une ou plusieurs des caractéristiques suivantes.

Selon une caractéristique de l'invention, l'étape e) est exécutée de sorte que les piliers métalliques affleurent le matériau.

Ainsi, un avantage procuré est d'éviter un mouillage des flancs des piliers métalliques lors de la formation ultérieure de billes de soudure.

Selon une caractéristique de l'invention, l'étape e) est exécutée par un polissage mécanique ou mécano-chimique des piliers métalliques.

L'étape e) peut être précédée d'un meulage («*grinding*» en langue anglaise) si l'épaisseur à polir des piliers métalliques est élevée, afin de limiter le temps d'opération.

Selon une caractéristique de l'invention, le procédé comporte une étape f) consistant à former des billes de soudure en contact avec les piliers métalliques à l'issue de l'étape e).

Le terme « bille de soudure » couvre également le terme de « bille de brasure » où le matériau d'apport est différent des matériaux à assembler.

Ainsi, un avantage procuré est de pouvoir établir une liaison électrique avec une carte électronique (ou avec un boîtier).

Selon une caractéristique de l'invention, l'étape a) comporte les étapes :

  a₁) prévoir un premier substrat sur lequel est formé l'ensemble de puces électroniques ;
  a₂) assembler un substrat temporaire à l'ensemble

de puces électroniques ;

a$_3$) amincir le premier substrat jusqu'à l'obtention de la première couche ;

a$_4$) former des trous d'interconnexions dans la première couche.

Ainsi, un avantage procuré par l'amincissement du premier substrat est de favoriser la mise en courbure des puces électroniques lors de l'étape d).

Selon une caractéristique de l'invention, l'étape a) est exécutée de sorte que :

- la couche d'interconnexions est formée sur la première couche ;
- l'ensemble de matrices de pixels est formée sur la couche d'interconnexions ;
- l'empilement comprend un ensemble de matrices de lentilles de focalisation, formé sur l'ensemble de matrices de pixels.

Ainsi, on obtient un capteur d'images de type BSI («*Back Side Illuminated*» en langue anglaise). La lumière incidente pénètre dans l'ensemble de matrices de pixels qui est situé en amont de la couche d'interconnexions, ce qui évite les déperditions énergétiques, et par là-même augmente la sensibilité du capteur d'images.

Selon une caractéristique de l'invention, l'étape a) est exécutée de sorte que :

- l'ensemble de matrices de pixels est formé sur la première couche ;
- la couche d'interconnexions est formée sur l'ensemble de matrices de pixels ;
- l'empilement comprend un ensemble de matrices de lentilles de focalisation, formé sur la couche d'interconnexions.

Ainsi, on obtient un capteur d'images de type FSI («*Front Side Illuminated*» en langue anglaise). La lumière incidente pénètre par la couche d'interconnexions et l'ensemble de matrices de pixels est situé en aval de la couche d'interconnexions.

Selon une caractéristique de l'invention, l'étape c) est exécutée de sorte que le matériau est un polymère thermodurcissable, de préférence choisi parmi une résine époxy et une résine polysiloxane.

Ainsi, un avantage procuré est de pouvoir mouler le matériau à l'aide d'un moule d'injection.

Selon une caractéristique de l'invention, l'étape c) est exécutée de sorte que les premier et second coefficients de dilatation thermique vérifient : $\dfrac{\alpha_2}{\alpha_1} \geq 4$ , préférentiellement $\dfrac{\alpha_2}{\alpha_1} \geq 6$ , où :

- $\alpha_1$ est le coefficient de dilatation thermique de l'empilement,
- $\alpha_2$ est le coefficient de dilatation thermique du matériau.

Ainsi, un avantage procuré est d'autoriser des rayons de courbure élevés pour la forme convexe, et par là-même pour les puces électroniques. Le rayon de courbure peut être calculé en fonction de $\alpha_1$ et de $\alpha_2$ par la formule de Stoney.

Selon une caractéristique de l'invention, l'étape c) est exécutée de sorte que le matériau possède un module de Young supérieur à 100 MPa, de préférence supérieur à 1 GPa, plus préférentiellement supérieur à 3 GPa.

Ainsi, un avantage procuré est d'obtenir une rigidité satisfaisante du matériau autorisant la courbure souhaitée de l'empilement lors de l'étape d).

**Brève description des dessins**

D'autres caractéristiques et avantages apparaîtront dans l'exposé détaillé de différents modes de réalisation de l'invention, l'exposé étant assorti d'exemples et de références aux dessins joints.

Figures 1a à 1k sont des vues schématiques en coupe illustrant un premier mode de mise en œuvre d'un procédé selon l'invention pour un capteur d'images de type FSI.

Figures 2a à 2k sont des vues schématiques en coupe illustrant un premier mode de mise en œuvre d'un procédé selon l'invention pour un capteur d'images de type BSI.

Figure 3 est une vue schématique partielle en coupe d'un capteur d'images de type FSI prévu lors de l'étape a) d'un procédé selon l'invention.

Figure 4 est une vue schématique partielle en coupe d'un capteur d'images de type BSI prévu lors de l'étape a) d'un procédé selon l'invention. Les traits pointillés désignent l'interface de collage.

Figure 5 est une vue schématique partielle en coupe d'un capteur d'images empilé de type BSI («*3D stacked BSI*» en langue anglaise) prévu lors de l'étape a) d'un procédé selon l'invention. Les traits pointillés désignent l'interface de collage.

Il est à noter que les dessins décrits ci-avant sont schématiques et ne sont pas à l'échelle par souci de lisibilité et pour simplifier leur compréhension.

**Exposé détaillé des modes de réalisation**

Les éléments identiques ou assurant la même fonction porteront les mêmes références pour les différents modes de réalisation, par souci de simplification.

Un objet de l'invention est un procédé de mise en courbure collective d'un ensemble de puces électroniques P, comportant les étapes :

a) prévoir l'ensemble de puces électroniques P, comportant un empilement comprenant :

- un ensemble de matrices de pixels 2,
- une couche d'interconnexions 3, reliée électriquement à l'ensemble de matrices de pixels 2,
- une première couche 1, comprenant des trous d'interconnexions 100 reliés électriquement à la couche d'interconnexions 3 ;
l'empilement possédant une première épaisseur et un premier coefficient de dilatation thermique ;

b) former des piliers métalliques 4 sur la première couche 1, reliés électriquement aux trous d'interconnexions 100 ;

c) former un matériau 5 de manière solidaire avec la première couche 1, autour des piliers métalliques 4 ; le matériau 5 possédant une seconde épaisseur, un second coefficient de dilatation thermique strictement supérieur au premier coefficient de dilatation thermique, et une température de formation ;

d) découper les puces électroniques P de manière à libérer les contraintes thermomécaniques subies par l'empilement ; la température de formation, le ratio entre les premier et second coefficients de dilatation thermique et le ratio entre les première et seconde épaisseurs étant adaptés de sorte qu'à l'issue de l'étape d), l'empilement est incurvé selon une forme convexe prédéterminée, orientée vers l'ensemble de matrices de pixels 2, à une température de fonctionnement donnée des puces électroniques P ;

e) rendre coplanaires les piliers métalliques 4 après l'étape d).

## Première couche

La première couche 1 comprend des première et seconde surfaces 10, 11 opposées. La première couche 1 est avantageusement obtenue à partir d'un premier substrat 1' aminci pour favoriser la mise en courbure des puces électroniques P. La première couche 1 présente avantageusement une épaisseur inférieure à 500 $\mu$m, préférentiellement inférieure à 100 $\mu$m, plus préférentiellement inférieure à 50 $\mu$m. Une telle gamme d'épaisseur permet de favoriser la mise en courbure lors de l'étape d). La première couche 1 est avantageusement réalisée dans un matériau semi-conducteur, de préférence le silicium. Dans le cas où la première couche 1 est réalisée en silicium, les trous d'interconnexion 100 sont de type TSV («*Through Silicon Via*» en langue anglaise).

## Capteur d'images FSI

L'étape a) peut être exécutée de sorte que :

- l'ensemble de matrices de pixels 2 est formé sur la première couche 1 ;
- la couche d'interconnexions 3 est formée sur l'ensemble de matrices de pixels 2 ;
- l'empilement comprend un ensemble de matrices de lentilles de focalisation 6, formé sur la couche d'interconnexions 3.

Plus précisément, l'ensemble de matrices de pixels 2 est formé à la première surface 10 de la première couche 1. Les piliers métalliques 4 sont formés lors de l'étape b) à la seconde surface 11 de la première couche 1. Par « formé à la surface », on entend formé sur ou à travers la surface.

Ainsi, lorsque les puces électroniques P sont des capteurs d'images de type FSI («*Front Side Illuminated*» en langue anglaise), la lumière incidente pénètre par la couche d'interconnexions 3 et l'ensemble de matrices de pixels 2 est situé en aval de la couche d'interconnexions 3.

Il est à noter que les matrices de lentilles de focalisation 6 peuvent être optionnelles pour certains types de capteurs, notamment pour les capteurs infrarouges refroidis.

## Capteur d'images BSI

L'étape a) peut être exécutée de sorte que :

- la couche d'interconnexions 3 est formée sur la première couche 1 ;
- l'ensemble de matrices de pixels 2 est formé sur la couche d'interconnexions 3 ;
- l'empilement comprend un ensemble de matrices de lentilles de focalisation 6, formé sur l'ensemble de matrices de pixels 2.

Plus précisément, la couche d'interconnexions 3 est formée à la première surface 10 de la première couche 1. Les piliers métalliques 4 sont formés lors de l'étape b) à la seconde surface 11 de la première couche 1. Par « formé à la surface », on entend formé sur ou à travers la surface.

Ainsi, lorsque les puces électroniques P sont des capteurs d'images de type BSI («*Back Side Illuminated*» en langue anglaise), la lumière incidente pénètre dans l'ensemble de matrices de pixels 2 qui est situé en amont de la couche d'interconnexions 3, ce qui évite les déperditions énergétiques, et par là-même augmente la sensibilité du capteur d'images.

Il est à noter que les matrices de lentilles de focalisation 6 peuvent être optionnelles pour certains types de capteurs, notamment pour les capteurs infrarouges refroidis.

## Couche d'interconnexions

La couche d'interconnexions 3 est un empilement de niveaux d'interconnexions comprenant des pistes métalliques noyées dans un matériau diélectrique. A titre d'exemples non limitatifs, les pistes métalliques peuvent être réalisées en cuivre ou en aluminium, et le matériau diélectrique peut être organique (un polymère tel qu'un polyimide, ou ALX commercialisé par la société ASAHI GLASS) ou inorganique ($SiO_2$, SiN...). La couche d'interconnexion 3 peut être une couche de redistribution (RDL pour «*ReDistribution Layer*» en langue anglaise) des connexions électriques au sein d'un interposeur.

## Matrices de pixels

Les pixels 2 peuvent être des cellules photosensibles (appelées également photosites) dans le cas d'une puce électronique P d'un capteur d'images. Les pixels 2 peuvent être des cellules émettrices de lumière (ou émissives) dans le cas d'une puce électronique P d'un afficheur.

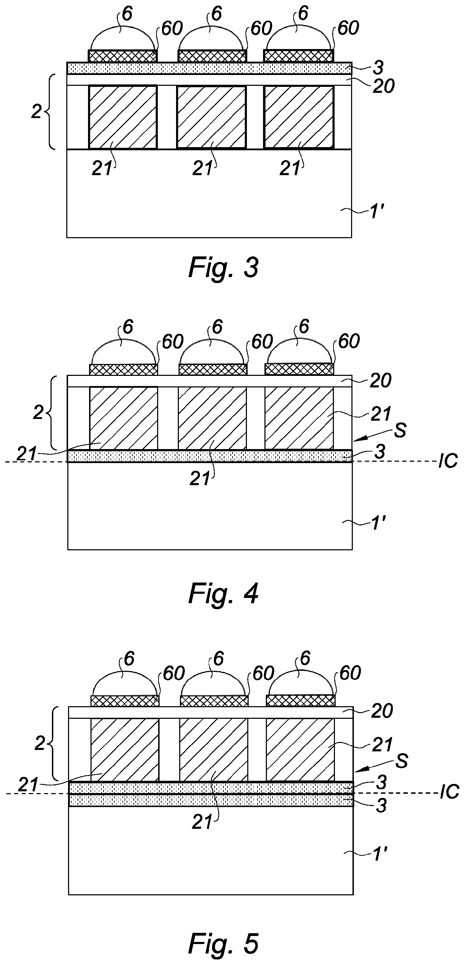

Comme illustré aux figures 3 à 5, lorsque la puce électronique P est un capteur d'images, les matrices de pixels 2 sont avantageusement munies de photodiodes 21 reliées à la surface de réception 20 de la lumière incidente. Les matrices de pixels 2 sont avantageusement munies de circuits de type CMOS («*Complementary Métal Oxide Semiconductor*» en langue anglaise) configurés pour traiter le signal électrique généré par les photodiodes 21 (amplification du signal, sélection du pixel...).

Lorsque la puce électronique P est un afficheur, les matrices de pixels 2 sont avantageusement munies de diodes électroluminescentes (non illustrées). Les matrices de pixels 2 sont avantageusement munies de circuits de type CMOS configurés pour commander les diodes électroluminescentes.

Comme illustré aux figures 3 à 5, les matrices de pixels 2 sont avantageusement munies de filtres colorés 60. Lorsque la puce électronique P est un capteur d'images, les filtres colorés 60 sont avantageusement agencés en matrice de Bayer. Les filtres colorés 60 sont interposés entre la surface de réception 20 de la lumière incidente et les matrices de lentilles de focalisation 6.

## Matrices de lentilles de focalisation

Dans le cas d'une puce électronique P d'un capteur d'images comportant des matrices de lentilles de focalisation 6, les lentilles de focalisation 6 sont convergentes de manière à concentrer la lumière incidente vers les matrices de pixels 2. Chaque lentille de focalisation 6 est associée à un pixel. Les lentilles de focalisation 6 sont préférentiellement des microlentilles.

## Matériau

Le matériau 5 est solidaire mécaniquement de la première couche 1 de l'empilement. A cet effet, le matériau 5 est choisi de manière à présenter une énergie d'adhérence satisfaisante pour obtenir la mise en courbure et éviter son décollement de l'empilement à la température de fonctionnement donnée des puces électroniques P.

Les premier et second coefficients de dilatation thermique sont avantageusement choisis de sorte que :

$$\frac{\alpha_2}{\alpha_1} \geq 4$$
, préférentiellement 
$$\frac{\alpha_2}{\alpha_1} \geq 6$$
, où :

- $\alpha_1$ est le coefficient de dilatation thermique de l'empilement,
- $\alpha_2$ est le coefficient de dilatation thermique du matériau 5.

Il est possible de mesurer le coefficient de dilatation thermique de l'empilement par une technique connue de l'homme du métier, comme décrit dans le chapitre 2 du document «ASM Ready Reference : Thermal Properties of Metals», ASM International, 2002, ou encore dans le document B. Cassel et al., «Coefficient ofThermal Expansion Measurement using the TMA 4000 », PerkinElmer, Inc., 2013.

En première approximation, le coefficient de dilatation thermique de l'empilement est sensiblement égal au coefficient de dilatation thermique de la première couche 1 dans la mesure où l'épaisseur de la première couche 1 est prédominante dans l'empilement. Lorsque la première couche 1 est réalisée en silicium, $\alpha_1$ est de l'ordre de $2,5 \cdot 10^{-6}$ $K^{-1}$. On choisira donc le matériau 5 avec $\alpha_2$ tel que $\alpha_2 \geq 10^{-5}$ $K^{-1}$, préférentiellement $\alpha_2 \geq 1,5 \cdot 10^{-5}$ $K^{-1}$. Le rayon de courbure obtenu à l'issue de l'étape d) peut être calculé en fonction de $\alpha_1$ et $\alpha_2$ grâce à la formule de Stoney, connue de l'homme du métier.

Le matériau 5 possède avantageusement un module de Young supérieur à 100 MPa, de préférence supérieur à 1 GPa, plus préférentiellement supérieur à 3 GPa.

Le matériau 5 présente avantageusement une seconde épaisseur comprise entre 120 $\mu m$ et 600 $\mu m$. Le matériau 5 peut être monocouche ou multicouche. En première approximation, le ratio entre la première épaisseur (de l'empilement) et la seconde épaisseur (du matériau 5) qui influence la courbure de la forme convexe peut être considéré comme gouverné par le ratio entre l'épaisseur de la première couche 1 et la seconde épaisseur dans la mesure où l'épaisseur de la première couche 1 est prédominante dans l'empilement. On choisira de préférence une seconde épaisseur du matériau 5 de l'ordre de 2,5 fois supérieure à l'épaisseur de la première couche 1 lorsque la première couche 1 est en silicium afin d'optimiser la courbure de la forme convexe selon l'application envisagée. Lorsque le matériau 5 est poli lors de l'étape e), la seconde épaisseur du matériau 5 poli est avantageusement au moins 2 fois supérieure à l'épaisseur de la première couche 1 lorsque la première couche 1 est en silicium. Ainsi, la courbure de la forme convexe est peu affectée lors de l'étape e).

L'étape a) peut être exécutée de sorte que le matériau 5 est un polymère thermodurcissable, de préférence choisi parmi une résine époxy et une résine polysiloxane. Le cas échéant, le second coefficient de dilatation thermique est le coefficient de dilatation thermique du polymère durci. A titre d'exemples non limitatifs, le polymère thermodurcissable peut être :

- une résine époxy, avec un module de Young de l'ordre de 9 GPa, $\alpha_2$ compris entre $3,1\ 10^{-5}$ K$^{-1}$ et $1,14\ 10^{-4}$ K$^{-1}$, et une température de réticulation de l'ordre de 71°C ;
- une résine polysiloxane, avec un module de Young de l'ordre de 3,3 GPa, $\alpha_2$ compris entre $2\ 10^{-5}$ K$^{-1}$ et $9,1\ 10^{-5}$ K$^{-1}$, et une température de réticulation de l'ordre de 180°C.

Le polymère thermodurcissable possède une température de formation (e.g. température de réticulation) strictement supérieure à la température de fonctionnement donnée des puces électroniques P.

### Piliers métalliques

Les piliers métalliques 4 sont de préférence réalisés en aluminium ou en cuivre.

Par exemple, une couche de germination métallique («*seed layer*» en langue anglaise) peut être déposée sur la première couche 1.

La couche de germination permet le contact électrique pleine plaque pour la future croissance électrochimique des piliers métalliques 4. La couche de germination peut présenter une épaisseur de l'ordre de 300 nm. Ensuite, une résine de photolithographie peut être déposée sur la couche de germination, puis exposée à un rayonnement ultraviolet à travers un masque de manière à former des motifs délimitant les futurs piliers métalliques 4. L'épaisseur de la résine de photolithographie est choisie de manière à être égale à la hauteur des futurs piliers métalliques 4. La couche de germination est ensuite polarisée dans un bain dédié permettant la croissance électrochimique des piliers métalliques 4. Enfin, la résine de photolithographie est retirée, et la partie de la couche de germination s'étendant sous la résine de photolithographie lors de la croissance électrochimique est gravée.

### Découpe de l'étape d)

A titre d'exemples non limitatifs, l'étape d) peut être exécutée à l'aide d'une scie circulaire de précision, avec une lame à âme métallique ou à âme résinoïde diamantée.

### Forme convexe prédéterminée

La forme convexe prédéterminée peut avoir un rayon de courbure constant ou variable (de même signe). La forme convexe prédéterminée peut être asphérique.

Le rayon de courbure (constant ou variable) est prédéterminé selon l'application envisagée.

### Etape e) de coplanarité

L'étape e) peut être exécutée par un polissage mécanique ou mécano-chimique des piliers métalliques 4.

L'étape e) est avantageusement exécutée de sorte que les piliers métalliques 4 affleurent le matériau 5 à l'issue de l'étape e). L'étape e) peut s'accompagner d'un polissage du matériau 5 selon l'épaisseur des piliers métalliques 4 en saillie du matériau 5.

Le procédé comporte avantageusement une étape f) consistant à former des billes de soudure BS en contact avec les piliers métalliques 4 à l'issue de l'étape e).

### Application au capteur d'images FSI

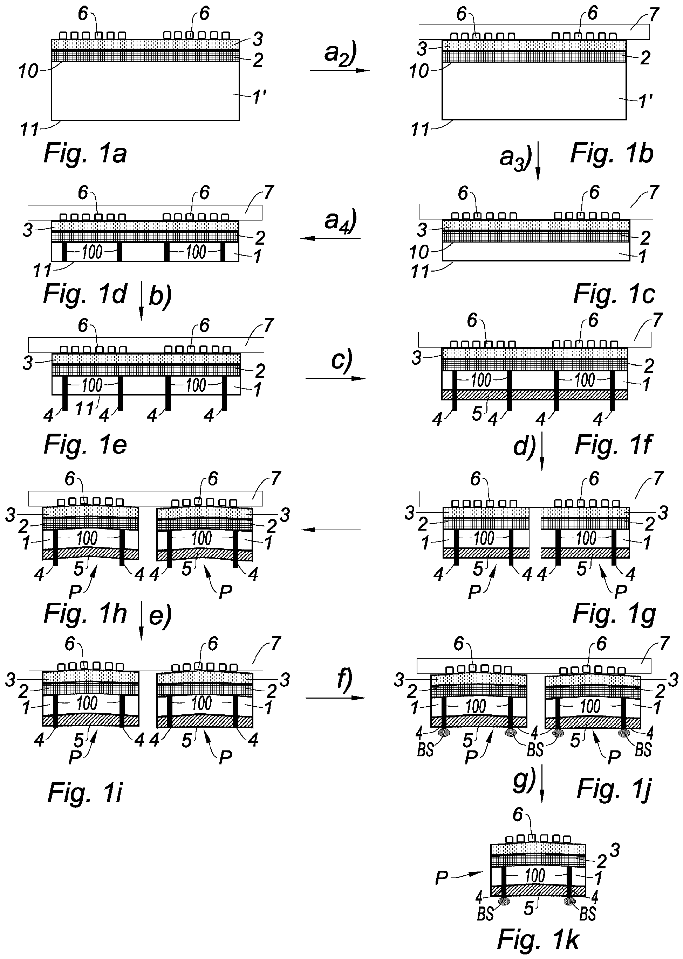

Ce mode de mise en œuvre est illustré aux figures 1a à 1k.

L'étape a) est exécutée de sorte que :

- la couche d'interconnexions 3 est formée à la première surface 10 de la première couche 1 ;
- l'ensemble de matrices de pixels 2 est formé sur la couche d'interconnexions 3 ;
- l'empilement comprend un ensemble de matrices de lentilles de focalisation 6, formé sur l'ensemble de matrices de pixels 2.

L'étape a) peut comporter les étapes :

a$_1$) prévoir un premier substrat 1', sur lequel est formé l'ensemble de puces électroniques P ;
a$_2$) assembler un substrat temporaire 7 à l'ensemble de puces électroniques P ; (illustré à la figure 1b)
a$_3$) amincir le premier substrat 1' jusqu'à l'obtention de la première couche 1 (illustré à la figure 1c) ;
a$_4$) former les trous d'interconnexions 100 dans la première couche 1 (illustré à la figure 1d).

L'étape a$_2$) est exécutée de sorte que le substrat temporaire 7 est assemblé à la couche d'interconnexions 3. A titre d'exemple non limitatif, le substrat temporaire 7 assemblé lors de l'étape a$_2$) peut être un film adhésif, agencé du côté de la couche d'interconnexions 3, et aspiré par un plateau de maintien à vide d'une tranche («*vacuum chuck*» en langue anglaise). L'utilisation du substrat temporaire 7 autorise l'amincissement du premier substrat 1' afin d'assurer la tenue mécanique de l'empilement.

L'étape a$_3$) est préférentiellement exécutée par un polissage mécano-chimique, précédé d'un meulage («*grinding*» en langue anglaise).

Comme illustré à la figure 1d, l'étape a$_4$) consiste à former des trous d'interconnexions 100, traversant la première couche 1, et reliés électriquement à la couche d'interconnexions 3.

Comme illustré à la figure 1e, les piliers métalliques 4 sont formés lors de l'étape b), à la seconde surface 11 de la première couche 1, en contact avec les trous d'interconnexions 100, par exemple par la technique décrite précédemment au paragraphe intitulé « Piliers métalliques ».

Comme illustré à la figure 1f, le matériau 5 est formé sur la seconde surface 11 de la première couche 1 lors de l'étape c) de manière solidaire avec l'empilement, autour des piliers métalliques 4. L'étape c) peut être exécutée par un dépôt conforme.

L'étape d) de découpe est illustrée à la figure 1g et la libération des contraintes thermomécaniques subies par l'empilement est illustrée à la figure 1h. Il est à noter que les déformations subies lors de l'étape d) par le substrat temporaire 7 ne sont pas illustrées à la figure 1h. En raison de la topologie de surface du substrat temporaire 7 à l'issue de l'étape d), une poignée (non illustrée) est assemblée au substrat temporaire 7 avant l'étape e), par une technique particulière, telle que le procédé CONDOx connu de l'homme du métier, notamment décrit dans le document US 2017/0062278. La poignée peut comporter une résine durcissable aux rayons ultraviolets (e.g. la résine ResiFlat commercialisée par DISCO Corporation ou la résine Temploc commercialisée par DENKA), assemblée au substrat temporaire 7 par l'intermédiaire d'un film protecteur. La résine est assemblée au film protecteur grâce à un support assurant la tenue mécanique de la résine, le support pouvant être réalisé en verre ou en polytéréphtalate d'éthylène (PET). La poignée peut être retirée ultérieurement du substrat temporaire 7 en retirant dans un premier temps la résine et le support, puis en retirant dans un second temps le film protecteur par un traitement adapté, par exemple par rayonnement ultraviolets ou par un agent chimique.

Comme illustré à la figure 1i, l'étape e) peut être exécutée par un polissage mécano-chimique des piliers métalliques 4. L'étape e) peut être précédée d'un meulage (« *grinding* » en langue anglaise) si l'épaisseur à polir des piliers métalliques 4 est élevée, afin de limiter le temps d'opération.

Comme illustré à la figure 1j, le procédé peut comporter une étape f) consistant à former des billes de soudure BS en contact avec les piliers métalliques 4 à l'issue de l'étape e).

Enfin, comme illustré à la figure 1k, le substrat temporaire 7 est retiré lors d'une étape g) afin de monter les puces électroniques P sur une carte électronique ou dans un boîtier.

## Application au capteur d'images BSI

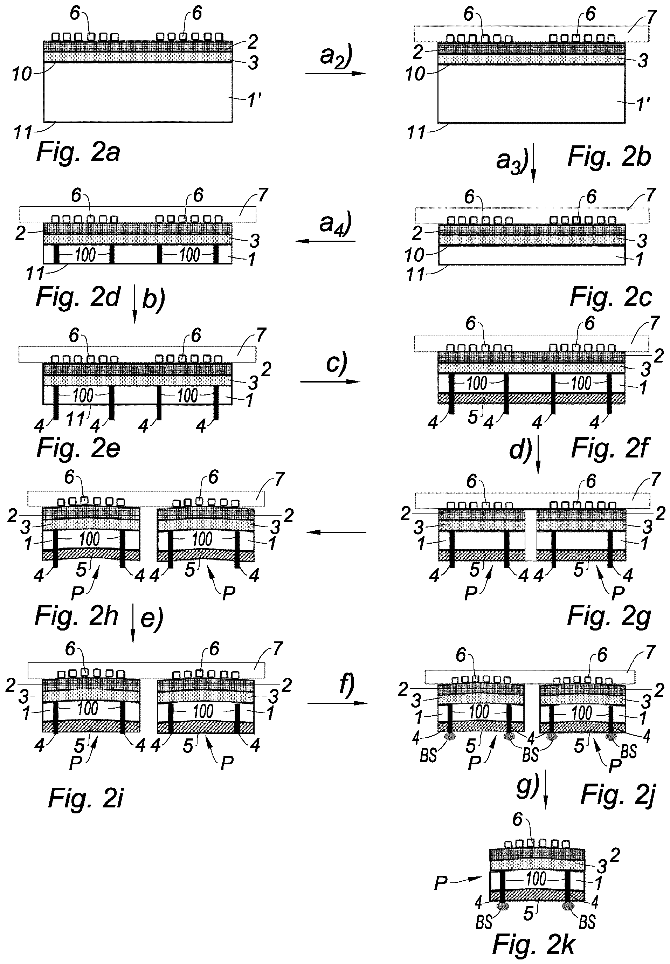

Ce mode de mise en œuvre est illustré aux figures 2a à 2k.

L'étape a) est exécutée de sorte que :

- la couche d'interconnexions 3 est formée à la première surface 10 de la première couche 1 ;
- l'ensemble de matrices de pixels 2 est formé sur la couche d'interconnexions 3 ;
- l'empilement comprend un ensemble de matrices de lentilles de focalisation 6, formé sur l'ensemble de matrices de pixels 2.

L'étape a) peut comporter les étapes :

$a_1$) prévoir un premier substrat 1' sur lequel est formé l'ensemble de puces électroniques P ;
$a_2$) assembler un substrat temporaire 7 à l'ensemble de puces électroniques P ; (illustré à la figure 2b)
$a_3$) amincir le premier substrat 1' jusqu'à l'obtention de la première couche 1 ; (illustré à la figure 2c) ;
$a_4$) former les trous d'interconnexions 100 dans la première couche 1 (illustré à la figure 2d).

Comme illustré aux figures 4 et 5, l'ensemble de puces électroniques P peut être formé avant l'étape $a_1$) au sein d'un substrat S qui est ensuite collé au premier substrat 1'. Les traits pointillés désignent l'interface de collage IC. Comme illustré à la figure 5, le premier substrat 1' peut être muni d'un circuit de lecture capable de lire simultanément chaque pixel d'une matrice formée dans le substrat S.

L'étape $a_2$) est exécutée de sorte que le substrat temporaire 7 est assemblé à l'ensemble de matrices de pixels 2. A titre d'exemple non limitatif, le substrat temporaire 7 assemblé lors de l'étape $a_2$) peut être un film adhésif, agencé du côté de l'ensemble de matrices de pixels 2, et aspiré par un plateau de maintien à vide d'une tranche (« *vacuum chuck* » en langue anglaise). L'utilisation du substrat temporaire 7 autorise l'amincissement du premier substrat 1' afin d'assurer la tenue mécanique de l'empilement.

L'étape $a_3$) est préférentiellement exécutée par un polissage mécano-chimique, précédé d'un meulage (« *grinding* » en langue anglaise).

Comme illustré à la figure 2d, l'étape $a_4$) consiste à former des trous d'interconnexions 100, traversant la première couche 1, et reliés électriquement à la couche d'interconnexions 3.

Comme illustré à la figure 2e, les piliers métalliques 4 sont formés lors de l'étape b), à la seconde surface 11 de la première couche 1, en contact avec les trous d'interconnexions 100, par exemple par la technique décrite précédemment au paragraphe intitulé « Piliers métalliques ».

Comme illustré à la figure 2f, le matériau 5 est formé sur la seconde surface 11 de la première couche 1 lors de l'étape c) de manière solidaire avec l'empilement, autour des piliers métalliques 4. L'étape c) peut être exécutée par un dépôt conforme.

L'étape d) de découpe est illustrée à la figure 2g et la libération des contraintes thermomécaniques subies par l'empilement est illustrée à la figure 2h. Il est à noter que les déformations subies lors de l'étape d) par le substrat temporaire 7 ne sont pas illustrées à la figure 2h. En raison de la topologie de surface du substrat temporaire 7 à l'issue de l'étape d), une poignée (non illustrée) est assemblée au substrat temporaire 7 avant l'étape e), par une technique particulière, telle que le procédé CONDOx connu de l'homme du métier, notamment décrit dans le document US 2017/0062278 (cf. paragraphe précédent pour les modalités de mise en œuvre).

Comme illustré à la figure 2i, l'étape e) peut être exécutée par un polissage mécano-chimique des piliers métalliques 4. L'étape e) peut être précédée d'un meulage («*grinding*» en langue anglaise) si l'épaisseur à polir des piliers métalliques 4 est élevée, afin de limiter le temps d'opération.

Comme illustré à la figure 2j, le procédé peut comporter une étape f) consistant à former des billes de soudure BS en contact avec les piliers métalliques 4 à l'issue de l'étape e).

Enfin, comme illustré à la figure 2k, le substrat temporaire 7 est retiré lors d'une étape g) afin de monter les puces électroniques P sur une carte électronique ou dans un boîtier.

**Revendications**

1.   Procédé de mise en courbure collective d'un ensemble de puces électroniques (P), comportant les étapes :

    a) prévoir l'ensemble de puces électroniques (P), comportant un empilement comprenant :

        - un ensemble de matrices de pixels (2),
        - une couche d'interconnexions (3), reliée électriquement à l'ensemble de matrices de pixels (2),
        - une première couche (1), comprenant des trous d'interconnexions (100) reliés électriquement à la couche d'interconnexions (3) ; l'empilement possédant une première épaisseur et un premier coefficient de dilatation thermique ;

    b) former des piliers métalliques (4) sur la première couche (1), reliés électriquement aux trous d'interconnexions (100) ;
    c) former un matériau (5) de manière solidaire avec la première couche (1), autour des piliers métalliques (4) ; le matériau possédant une seconde épaisseur, un second coefficient de dilatation thermique strictement supérieur au premier coefficient de dilatation thermique, et une température de formation ;
    d) découper les puces électroniques (P) de manière à libérer les contraintes thermomécaniques subies par l'empilement ; le procédé étant **caractérisé en ce que** la température de formation, le ratio entre les premier et second coefficients de dilatation thermique et le ratio entre les première et seconde épaisseurs sont adaptés de sorte qu'à l'issue de l'étape d), l'empilement est incurvé selon une forme convexe prédéterminée, orientée vers l'ensemble de matrices de pixels (2), à une température de fonctionnement donnée des puces électroniques (P) ; et **en ce qu'**il comporte l'étape:
    e) rendre coplanaires les piliers métalliques (4) après l'étape d).

2.   Procédé selon la revendication 1, dans lequel l'étape e) est exécutée de sorte que les piliers métalliques (4) affleurent le matériau (5).

3.   Procédé selon la revendication 1 ou 2, dans lequel l'étape e) est exécutée par un polissage mécanique ou mécano-chimique des piliers métalliques (4).

4.   Procédé selon l'une des revendications 1 à 3, comportant une étape f) consistant à former des billes de soudure (BS) en contact avec les piliers métalliques (4) à l'issue de l'étape e).

5.   Procédé selon l'une des revendications 1 à 4, dans lequel l'étape a) comporte les étapes :

    $a_1$) prévoir un premier substrat (1') sur lequel est formé l'ensemble de puces électroniques (P) ;
    $a_2$) assembler un substrat temporaire (7) à l'ensemble de puces électroniques (P) ;
    $a_3$) amincir le premier substrat (1') jusqu'à l'obtention de la première couche (1) ;
    $a_4$) former les trous d'interconnexions (100) dans la première couche (1).

6.   Procédé selon l'une des revendications 1 à 5, dans lequel l'étape a) est exécutée de sorte que :

    - la couche d'interconnexions (3) est formée sur la première couche (1) ;
    - l'ensemble de matrices de pixels (2) est formé sur la couche d'interconnexions (3) ;
    - l'empilement comprend un ensemble de matrices de lentilles de focalisation (6), formé sur l'ensemble de matrices de pixels (2).

7.   Procédé selon l'une des revendications 1 à 5, dans lequel l'étape a) est exécutée de sorte que :

    - l'ensemble de matrices de pixels (2) est formé sur la première couche (1) ;
    - la couche d'interconnexions (3) est formée sur l'ensemble de matrices de pixels (2) ;
    - l'empilement comprend un ensemble de matrices de lentilles de focalisation (6), formé sur la couche d'interconnexions (3).

**8.** Procédé selon l'une des revendications 1 à 7, dans lequel l'étape c) est exécutée de sorte que le matériau (5) est un polymère thermodurcissable, de préférence choisi parmi une résine époxy et une résine polysiloxane.

**9.** Procédé selon l'une des revendications 1 à 8, dans lequel l'étape c) est exécutée de sorte que les premier et second coefficients de dilatation thermique

vérifient : $\frac{\alpha_2}{\alpha_1} \geq 4$ , préférentiellement $\frac{\alpha_2}{\alpha_1} \geq 6$ , où :

- $\alpha_1$ est le coefficient de dilatation thermique de l'empilement,
- $\alpha_2$ est le coefficient de dilatation thermique du matériau (5).

**10.** Procédé selon l'une des revendications 1 à 9, dans lequel l'étape c) est exécutée de sorte que le matériau (5) possède un module de Young supérieur à 100 MPa, de préférence supérieur à 1 GPa, plus préférentiellement supérieur à 3 GPa.

**Patentansprüche**

**1.** Verfahren zum kollektiven Biegen einer Gesamtheit von elektronischen Chips (P), umfassend die folgenden Schritte:

a) Bereitstellen der Gesamtheit von elektronischen Chips (P), umfassend ein Schichtsystem, das beinhaltet:

- eine Gesamtheit von Pixelmatrizen (2),
- eine Verbindungsschicht (3), die mit der Gesamtheit von Pixelmatrizen (2) elektrisch verbunden ist,
- eine erste Schicht (1), die Verbindungslöcher (100) beinhaltet, die mit der Verbindungsschicht (3) elektrisch verbunden sind; wobei das Schichtsystem eine erste Dicke und einen ersten Wärmeausdehnungskoeffizienten besitzt;

b) Formen der Metallpfeiler (4) auf der ersten Schicht (1), die mit den Verbindungslöchern (100) elektrisch verbunden sind;
c) Formen eines Materials (5) auf mit der ersten Schicht (1) fest verbundene Weise um die Metallpfeiler (4) herum; wobei das Material eine zweite Dicke, einen zweiten Wärmeausdehnungskoeffizienten, der strikt größer als der erste Wärmeausdehnungskoeffizient ist, und eine Formungstemperatur besitzt;
d) Ausschneiden der elektronischen Chips (P) derart, dass die vom Schichtsystem erfahrenen thermomechanischen Spannungen abgebaut werden; wobei das Verfahren **dadurch gekennzeichnet ist, dass** die Formungstemperatur, das Verhältnis zwischen den ersten und zweiten Wärmeausdehnungskoeffizienten und das Verhältnis zwischen den ersten und zweiten Dicken so angepasst sind, dass am Ende von Schritt d) das Schichtsystem gemäß einer vorbestimmten konvexen Form gebogen ist, die zu der Gesamtheit von Pixelmatrizen (2) hin ausgerichtet ist, bei einer gegebenen Betriebstemperatur der elektronischen Chips (P); und dass es den Schritt umfasst:
e) die Metallpfeiler (4) nach dem Schritt d) komplanar zu machen.

**2.** Verfahren nach Anspruch 1, bei dem der Schritt e) so ausgeführt wird, dass die Metallpfeiler (4) bündig mit dem Material (5) sind.

**3.** Verfahren nach Anspruch 1 oder 2, bei dem der Schritt e) durch ein mechanisches oder chemisch-mechanisches Polieren der Metallpfeiler (4) ausgeführt wird.

**4.** Verfahren nach einem der Ansprüche 1 bis 3, umfassend einen Schritt f), der darin besteht, am Ende des Schritts e) Schweißkugeln (BS) in Kontakt mit den Metallpfeilern (4) zu formen.

**5.** Verfahren nach einem der Ansprüche 1 bis 4, bei dem der Schritt a) die folgenden Schritte umfasst:

$a_1$) Bereitstellen eines ersten Substrats (1'), auf dem die Gesamtheit von elektronischen Chips (P) geformt ist;
$a_2$) Montieren eines temporären Substrats (7) an die Gesamtheit von elektronischen Chips (P);
$a_3$) Dünnen des ersten Substrats (1') bis zum Erhalten der ersten Schicht (1);
$a_4$) Formen der Verbindungslöcher (100) in der ersten Schicht (1).

**6.** Verfahren nach einem der Ansprüche 1 bis 5, bei dem der Schritt a) so ausgeführt wird, dass:

- die Verbindungsschicht (3) auf der ersten Schicht (1) geformt ist;
- die Gesamtheit von Pixelmatrizen (2) auf der Verbindungsschicht (3) geformt ist;
- das Schichtsystem eine Gesamtheit von Fokussierungslinsenmatrizen (6) umfasst, die auf der Gesamtheit von Pixelmatrizen (2) geformt ist.

**7.** Verfahren nach einem der Ansprüche 1 bis 5, bei dem der Schritt a) so ausgeführt wird, dass:

- die Gesamtheit von Pixelmatrizen (2) auf der ersten Schicht (1) geformt ist;
- die Verbindungsschicht (3) auf der Gesamtheit von Pixelmatrizen (2) geformt ist;
- das Schichtsystem eine Gesamtheit von Fokussierungslinsenmatrizen (6) umfasst, die auf der Verbindungsschicht (3) geformt ist.

**8.** Verfahren nach einem der Ansprüche 1 bis 7, bei dem der Schritt c) so ausgeführt wird, dass das Material (5) ein wärmehärtbares Polymer ist, das bevorzugt unter einem Epoxidharz und einem Polysiloxanharz ausgewählt ist.

**9.** Verfahren nach einem der Ansprüche 1 bis 8, bei dem der Schritt c) so ausgeführt wird, dass die ersten und zweiten Wärmeausdehnungskoeffizienten die folgende Bedingung erfüllen: $\dfrac{\alpha_2}{\alpha_1} \geq 4$ , bevorzugt $\dfrac{\alpha_2}{\alpha_1} \geq 6$ , worin:

- $\alpha_1$ der Wärmeausdehnungskoeffizient des Schichtsystems ist,
- $\alpha_2$ der Wärmeausdehnungskoeffizient des Materials (5) ist.

**10.** Verfahren nach einem der Ansprüche 1 bis 9, bei dem der Schritt c) so ausgeführt wird, dass das Material (5) einen Elastizitätsmodul von mehr als 100 MPa, bevorzugt mehr als 1 GPa, noch bevorzugter mehr als 3 GPa besitzt.

**Claims**

**1.** Process for collectively curving a set of electronic chips (P), including the steps of:

a) providing the set of electronic chips (P), including a stack comprising:

- a set of matrix arrays of pixels (2),
- an interconnect layer (3), electrically connected to the set of matrix arrays of pixels (2),
- a first layer (1), comprising vias (100) electrically connected to the interconnect layer (3);

the stack having a first thickness and a first coefficient of thermal expansion;
b) forming metal pillars (4) on the first layer (1), said pillars being electrically connected to the vias (100);
c) forming a material (5) integrally with the first layer (1), around the metal pillars (4); the material having a second thickness, a second coefficient of thermal expansion strictly higher than the first coefficient of thermal expansion, and a forming temperature;
d) dicing the electronic chips (P) so as to release the thermomechanical stresses to which the stack is subjected; the process being **characterized in that** the forming temperature, the ratio between the first and second coefficients of thermal expansion and the ratio between the first and second thicknesses are adapted such that, at the end of step d), the stack is curved with a predefined convex shape that is oriented towards the set of matrix arrays of pixels (2), at a given operating temperature of the electronic chips (P); and **in that** it includes the step of:
e) making the metal pillars (4) coplanar after step d).

**2.** Process according to Claim 1, wherein step e) is carried out such that the metal pillars (4) lie flush with the material (5).

**3.** Process according to Claim 1 or 2, wherein step e) is carried out via mechanical or chemical-mechanical polishing of the metal pillars (4).

**4.** Process according to one of Claims 1 to 3, including a step f) consisting in forming solder bumps (BS) in contact with the metal pillars (4) at the end of step e).

**5.** Process according to one of Claims 1 to 4, wherein step a) includes the steps of:

a$_1$) providing a first substrate (1') on which the set of electronic chips (P) is formed;
a$_2$) assembling a temporary substrate (7) with the set of electronic chips (P);
a$_3$) thinning the first substrate (1') until the first layer (1) is obtained;
a$_4$) forming the vias (100) in the first layer (1).

**6.** Process according to one of Claims 1 to 5, wherein step a) is carried out such that:

- the interconnect layer (3) is formed on the first layer (1);
- the set of matrix arrays of pixels (2) is formed on the interconnect layer (3);
- the stack comprises a set of matrix arrays of focusing lenses (6), which is formed on the set of matrix arrays of pixels (2).

**7.** Process according to one of Claims 1 to 5, wherein step a) is carried out such that:

- the set of matrix arrays of pixels (2) is formed on the first layer (1);
- the interconnect layer (3) is formed on the set of matrix arrays of pixels (2);
- the stack comprises a set of matrix arrays of focusing lenses (6), which is formed on the interconnect layer (3).

8. Process according to one of Claims 1 to 7, wherein step c) is carried out such that the material (5) is a thermosetting polymer, preferably chosen from an epoxy resin and a polysiloxane resin.

9. Process according to one of Claims 1 to 8, wherein step c) is carried out such that the first and second coefficients of thermal expansion satisfy: $\dfrac{\alpha_2}{\alpha_1} \geq 4$, preferably $\dfrac{\alpha_2}{\alpha_1} \geq 6$, where:

- $\alpha_1$ is the coefficient of thermal expansion of the stack,
- $\alpha_2$ is the coefficient of thermal expansion of the material (5).

10. Process according to one of Claims 1 to 9, wherein step c) is carried out such that the material (5) has a Young's modulus higher than 100 MPa, preferably higher than 1 GPa, more preferably higher than 3 GPa.

*Fig. 1a*

*a₂)*

*Fig. 1b*

*a₃)*

*a₄)*

*Fig. 1d*

*Fig. 1c*

*b)*

*Fig. 1e*

*c)*

*Fig. 1f*

*d)*

*Fig. 1h*

*Fig. 1g*

*e)*

*Fig. 1i*

*f)*

*g)*

*Fig. 1j*

*Fig. 1k*

Fig. 2a

Fig. 2b

Fig. 2d

Fig. 2c

Fig. 2e

Fig. 2f

Fig. 2h

Fig. 2g

Fig. 2i

Fig. 2j

Fig. 2k

Fig. 3

Fig. 4

Fig. 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20060038183 A1
- US 2009115875 A1
- US 20170062278 A

**Littérature non-brevet citée dans la description**

- ASM Ready Reference : Thermal Properties of Metals. ASM International. 2002
- **B. CASSEL et al.** Coefficient of Thermal Expansion Measurement using the TMA 4000. PerkinElmer, Inc, 2013